# EUROPÄISCHE PATENTSCHRIFT

(11) **EP 0 780 006 B1**
(45) Veröffentlichungstag und Bekanntmachung des Hinweises auf die Patenterteilung: **18.11.1998**
(21) Anmeldenummer: 95929753.2
(22) Anmeldetag: 05.09.1995
(51) Int. Cl.: G06K 19/077

(54) **VERFAHREN ZUR HERSTELLUNG EINES CHIPKARTENMODULS FÜR KONTAKTLOSE CHIPKARTEN**
PROCESS FOR PRODUCING A SMART CARD MODULE FOR CONTACTLESS SMART CARDS
PROCEDE DE FABRICATION D'UN MODULE DE CARTE A PUCE POUR CARTES A PUCE SANS CONTACT

(30) Priorität: 05.09.1994 DE 4431605
(43) Veröffentlichungstag der Anmeldung: 25.06.1997
(73) Patentinhaber: SIEMENS AKTIENGESELLSCHAFT, 80333 München (DE)
(72) Erfinder: MUNDIGL, Josef, D-93182 Duggendorf (DE); HOUDEAU, Detlef, D-84085 Langquaid (DE)
(86) Internationale Anmeldenummer: DE9501201
(87) Internationale Veröffentlichungsnummer: WO9607984

(56) Entgegenhaltungen:
- WO-A-93/09551
- WO-A-93/20537
- DE-A- 4 019 915

## Beschreibung

Bei kontakt- oder berührungslosen Chipkarten wird die zum Betreiben des in diesen enthaltenen Halbleiterchips notwendige Energie über zumindest eine Antennenspule zugeführt, wobei meistens eine transformatorische Übertragung gewählt wird. Auch der Datentransfer erfolgt über diese Spule.

Es sind dabei sowohl gedruckte, geätzte oder galvanisch aufgewachsene Spulen in Streifenleiterform als auch gewickelte Lackdrahtspulen üblich, wobei als Basismaterial für solche Lackdrahtspulen Kupfer verwendet wird.

Zur Verbindung der Spule mit dem Halbleiterchip werden zuerst die Anschlüsse der Spule durch z. B. Erhitzen, Bürsten, durch chemische Behandlung oder Verzinnen abisoliert und dann z. B. durch Laserlöten, Spaltschweißen, Ultraschall-Schweißen, Wire-Wrap oder Kleben mit Silberlackkleber kontaktiert. Zur Herstellung einer solchen Verbindung sind also jeweils eine Vielzahl unterschiedlicher Arbeitsgänge bzw. Montageschritte nötig, die auch mehrere Maschinen zu ihrer Durchführung erfordern.

Aus der DE 37 21 822 C1 ist es bekannt, eine Antennenspule über Bondverbindungen mit dem Halbleiterchip zu verbinden. Dort muß also zunächst eine Spule gewickelt werden, deren Enden dann in einem weiteren Arbeitsschritt über Bondverbindungen mit dem Halbleiterchip verbunden werden.

Aufgabe der Erfindung ist es, ein Verfahren zur Herstellung eines Chipkartenmoduls für eine kontaktlose Chipkarte anzugeben, das einfach, kostengünstig und leicht automatisierbar ist.

Die Aufgabe wird durch ein Verfahren gemäß Anspruch 1 gelöst. Eine vorteilhafte Weiterbildung der Erfindung ist in dem abhängigen Anspruch angegeben.

In erfindungsgemäßer Weise werden die Spulenanschlüsse direkt auf Kontaktfelder des Halbleiterchips gebondet. Der Bonder ist dabei direkt in den Drahtführungskopf des Spulenwickelautomaten integriert, so daß alle Montageschritte mit einer Maschine durchgeführt werden können. In besonders vorteilhafter Weise wird für die Spule ein Aluminiumdraht verwendet. Dieser ist mehr als halb so leicht wie Kupfer und hat auch einen nur etwa halb so großen Elastizitätsmodul, so daß die fertige Karte eine geringere Steifigkeit hat. Diese Art des Dickdrahtbondens ist z. B. aus der Leistungselektronik bekannt und wird gut beherrscht, so daß eine hohe Ausbeute erzielt wird.

In vorteilhafter Weiterbildung der Erfindung ist der Halbleiterchip frei schwebend nur durch die Bondkontakte gehalten in einer Ausnehmung eines Trägerkörpers angeordnet, so daß er gut vor Bruch bei Biegebeanspruchung der Chipkarte geschützt ist.

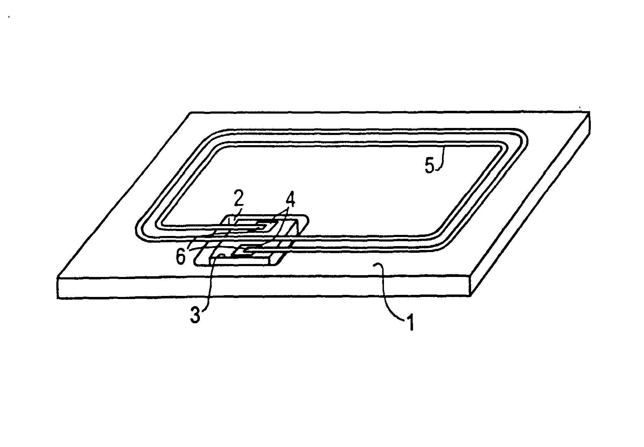

Die Erfindung wird nachfolgend anhand eines Ausführungsbeispiels mit Hilfe einer Figur näher erläutert. Die Figur zeigt dabei eine mögliche Ausführungsform eines erfindungsgemäßen Chipkartenmoduls.

Ein flacher Trägerkörper 1 aus flexiblem, nicht leitendem Material weist eine Ausnehmung 2 auf. In dieser ist ein Halbleiterchip 3 eingesetzt. Der Halbleiterchip 3 weist zwei Kontaktfelder 4 auf, die gegenüber den üblichen Chipkontaktfeldern durch z. B. eine Goldauflage vergrößert sind. Auf den Kontaktfeldern 4 sind die Anschlüsse 6 einer Antennenspule 5 durch Bondkontakte befestigt. Dabei wurde der Draht, der in vorteilhafter Weise aus Aluminium ist, zunächst auf eines der Kontaktfelder 4 gebondet, dann mittels des Führungskopfes eines Drahtwickelautomaten, in den der Bonder integriert ist, in mehreren Windungen zu einer Spule gewickelt (in der Figur sind nur zwei Windungen dargestellt, es können aber auch mehr sein; und zum Schluß wieder auf das andere Kontaktfeld gebondet. Anschließend wird der Halbleiterchip 3 mit der auf erfinderische Weise daran befestigten Spule 5 in die Ausnehmung 2 des Trägerkörpers 1 eingesetzt, so daß die Spule 5 auf dem Trägerkörper 1 angeordnet ist. Der Trägerkörper 1 kann dabei die Länge und Breite einer fertigen Chipkarte haben, so daß lediglich durch entsprechende Abdeckungen des Trägerkörpers die Chipkarte fertiggestelt werden kann. Der Trägerkörper 1 kann aber auch kleinere Abmessungen als eine Chipkarte aufweisen, so daß er als Inlet in einen rahmenförmigem Mittelteil der Chipkarte eingesetzt werden kann.

## Patentansprüche

1. Verfahren zur Herstellung eines Chipkartenmoduls mit folgenden Verfahrensschritten:
- ein Ende eines dünnen Drahtes wird auf ein erstes Kontaktfeld (4) eines Halbleiterchips (3) gebondet,
- der Draht wird mittels des Bondkopfes in mehreren Windungen (5) geführt,
- der Draht wird auf eine zweite Kontaktfläche (4) des Halbleiterchips (3) gebondet,
- die eine Antennenspule (5) bildenden Drahtwindungen und der Halbleiterchip (3) werden auf einem Trägerkörper (1) angeordnet.

2. Verfahren nach Anspruch 1, dadurch gekennzeichnet, daß die eine Antennenspule (5) bildenden Drahtwindungen derart auf dem Trägerkörper (1) angeordnet werden, daß der Halbleiterchip (3) in einer Ausnehmung (2) des Trägerkörpers (1) schwebend von den Bondverbindungen der Drahtenden (6) gehalten wird.

## Claims

1. Method for producing a smart card module, having the following method steps:
- one end of a thin wire is bonded onto a first contact zone (4) of a semiconductor chip (3),
- the wire is guided by means of the bonding head in a plurality of turns (5),
- the wire is bonded onto a second contact area (4) of the semiconductor chip (3),
- the wire turns forming an antenna coil (5) and the semiconductor chip (3) are arranged on a carrier body (1).

2. Method according to Claim 1, characterized in that the wire turns forming an antenna coil (5) are arranged on the carrier body (1) in such a way that the semiconductor chip (3) is held in a recess (2) in the carrier body (1) in a manner suspended from the bonds of the wire ends (6).

## Revendications

1. Procédé de fabrication d'un module de carte à puce comportant les étapes de procédé suivants :
- une extrémité d'un fil mince est liée par bonding à un premier panneau (4) de contact d'une puce (3) à semi-conducteurs,
- le fil est guidé au moyen de la tête de bonding en plusieurs spires (5).
- le fil est lié par bonding à une seconde surface (4) de contact de la puce (3) à semi-conducteurs,
- les spires de fil formant une bobine (5) antenne et la puce (3) à semi-conducteurs sont disposés sur un corps (1) formant support.

2. Procédé suivant la revendication 1, caractérisé en ce que les spires de fil formant une bobine antenne (5) sont disposés sur le corps (1) support de sorte que la puce (3) à semi-conducteurs est maintenue flottante dans un évidement (2) du corps (1) formant support par des liaisons de bonding des extrémités (6) de fil.
